# EUROPEAN PATENT APPLICATION

(11) **EP 3 720 000 A1**
(43) Date of publication of application: **07.10.2020**
(21) Application number: 19167494.4
(22) Date of filing: 05.04.2019
(51) Int. Cl.: H03K 17/693

(54) **MOSFET CURRENT SWITCH**

(71) Applicant: ICEpower a/s, 2860 Søborg (DK)
(72) Inventor: BOSTRÖM, Patrik, 256 57 RAMLÖSA (SE)
(74) Representative: AWA Sweden AB

(57) **Abstract**

An analogue current switch comprising an operational amplifier (2) having a positive input connected to ground, and a negative input, a first MOSFET (3) having a drain connected to the negative input of the operational amplifier and a source serving as an input of the analogue switch, a second MOSFET (4) having a drain connected to the source of the first field effect transistor and a source connected to ground, wherein a gate (12) of the first field effect transistor is connected to a control signal (13), and a gate (15) of the second field effect transistor is connected to an inverse (14) of said control signal.

The present invention provides an analogue current switch using MOSFETs, significantly lower internal non-linear resistance than JFETs (in the order of ten times lower), thereby improving system linearity. Also, MOSFETs are significantly easier to acquire at low cost.

## Description

### Field of the invention

The present invention relates to an analogue current switch, designed using commercially available components.

### Background of the invention

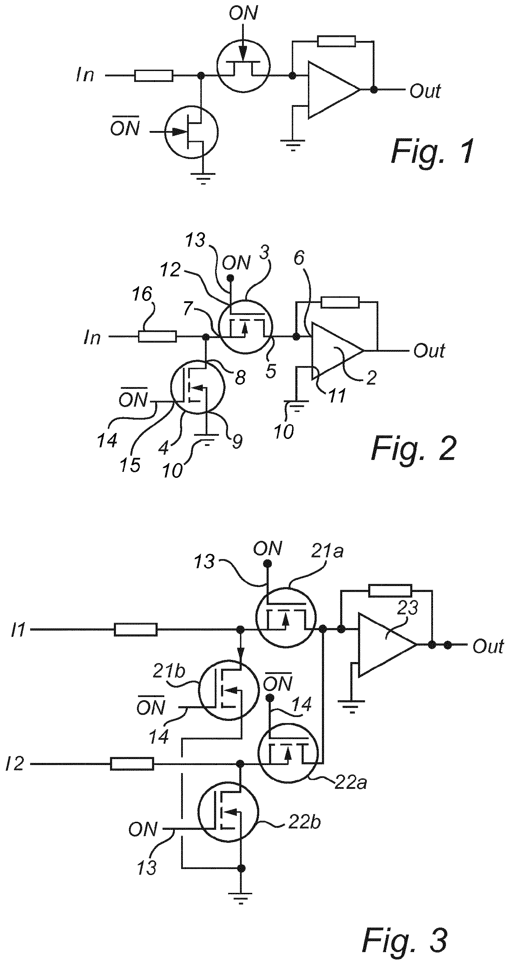

In some applications, a switch is required which allows switching a fixed current, either to a load or to ground. Such a switch is here referred to as a current switch. Douglas Self, "Small Signal Audio Design", first edition, 2010, has proposed an analogue current switch using junction field effect transistors (JFET). The circuit is shown in figure 1.

There are a few problems associated with JFETs. First, they are expensive and difficult to find. Second, the rather significant non-linear resistance of the JFET has a negative impact on the overall system linearity.

### General disclosure of the invention

The above problems are overcome by an analogue switch comprising an operational amplifier having a positive input connected to ground, and a negative input, a first field effect transistor connected between the negative input of the operational amplifier and a current-input terminal of the analogue switch, a second field effect transistor connected between the current-input terminal and ground, wherein a gate of the first field effect transistor is connected to a control signal, and a gate of the second field effect transistor is connected to an inverse of the control signal. The first and second field effect transistors are metal oxide semiconductor field effect transistors (MOSFETs).

When the control signal is ON, the first MOSFET will be ON, and any current provided at the input terminal will be connected through the first MOSFET to the op-amp and further to the output. When the control signal is OFF, the second MOSFET will be ON, and any current provided at the input terminal will be connected through the second MOSFET to ground.

It is noted that any noise at the gate of a MOSFET in an OFF state (e.g. interference from other users of the DC supply voltage used to generate the OFF control signal) will be primarily capacitively conducted to the source of the MOSFET. According to a preferred embodiment, therefore, the first field effect transistor has its drain connected to the negative input of the operational amplifier, and its source connected to the current-input terminal. Further, the second field effect transistor preferably has its drain connected to the current-input terminal (i.e. the source of the first field effect transistor), and its source connected to ground.

By connecting the first MOSFET with its drain to the op-amp input, any such interfering current generated at the gate of the first MOSFET will be conducted through the second MOSFET to ground. Similarly, by connecting the second MOSFET with its source to ground, any such interfering current generated at the gate of the second MOSFET will be conducted to ground, not to the signal path.

The present invention thus provides an analogue current switch using MOSFETs, significantly lower internal non-linear resistance than JFETs (in the order of ten times lower), thereby improving system linearity. Also, MOSFETs are significantly easier to acquire at low cost.

Given the significant advantages, it may appear as the use of MOSFETs in this type of switch would have been considered previously. However, it is noted a MOSFET, due to its inherent body diode, will conduct a reverse current. For this reason, JFETs, which do not allow any reverse current, have been the preferred choice, e.g. by Douglas Self. Indeed, it is noted that whenever MOSFETs previously have been used as an analogue current switch, two MOSFETS have been connected in series, source-to-source, to prevent any reverse current. It is only the present inventor who has realized that in a circuit according to the invention, the voltage across the MOSFETs (both the conducting MOSFET and the non-conducting MOSFET) is approximately zero. Therefore, there will not be any reverse diode current.

Further advantages with the approximately zero voltage across the MOSFETs are that the non-linear capacitance of the MOSFETs will not be modulated, the ON-resistance will not be modulated by varying gate-source voltage, and the OFF-signal isolation will be very high.

### Brief description of the drawings

The present invention will be described in more detail with reference to the appended drawings, showing currently preferred embodiments of the invention.
Figure 1 shows a prior art analogue current switch implemented by two JFETs.
Figure 2 shows an analogue switch according to an embodiment of the present invention.
Figure 3 shows two switches according to figure 2 combined in one switch.

### Detailed description of preferred embodiments

The analogue switch 1 in figure 2 includes an operational amplifier 2 and two enhancement mode, N-channel MOSFETs 3, 4. The first MOSFET 3 is connected with its drain 5 connected to the negative input 6 of the operational amplifier 2 and its source 7 serving as a current-input of the switch 1. The current-input may be preceded by an input resistance 16, for converting an input voltage to an input current, thus effectively making the switch serve as a voltage switch. The second MOSFET 4 is connected with its drain 8 connected to the source 7 of the first MOSFET 3 (i.e. also to the input of the switch 1) and with its a source 9 connected to ground 10. The positive input 11 of the operational amplifier is also connected to ground 10.

Further, the gate 12 of the first MOSFET 3 is connected to a control signal (ON/OFF) 13. An inverse 14 of the control signal 13 is connected to the gate 15 of the second MOSFET 4.

In use, when the control signal 13 is ON, the first MOSFET 3 will be ON and the second MOSFET 4 will be OFF. A current I input to the switch 1 will then pass through the conducting MOSFET 3 and be received by the op-amp 2. It is here noted that the negative input 6 of the op-amp is a virtual ground, such that the current to the op-amp sees virtually no resistance. As a consequence, there will be approximately zero voltage across the conducting MOSFET 3, and also approximately zero voltage across the non-conducting MOSFET 4.

When the control signal 13 is OFF, the first MOSFET 3 will be OFF, while the second MOSFET 4 will be ON. The input current I will then pass through the conducting MOSFET 4 to ground. Again, the voltage across the conducting MOSFET 4 will be approximately zero, and consequently also the voltage across the non-conducting MOSFET 3 will be approximately zero.

Any noise in the control signal 13 when it is in its OFF state will cause a current from the gate 12 to the source 7 of the first MOSFET 3. Such interference current will thus be connected to ground through the conducting MOSFET 4. Similarly, any noise in the inverse control signal 14 when it is in its OFF state will cause a current from the gate 15 to the source 9 of the second MOSFET 4. Such interference current will thus be connected directly to ground.

Figure 3 shows a further embodiment, where two pairs of MOSFETs 21a, 21b, 22a, 22b are combined to enable switching between two different currents 11 and 12. The first and second MOSFETs 21a, 21b are connected to an op-amp 23 in the same way as described with reference to figure 2, and receives the first current 11 as input. The third and fourth MOSFETs 22a, 22b are connected to the same op-amp 23 in a similar way. In other words, the third MOSFET 22a is connected with its drain to the negative input of the op-amp 23 and with its source receiving the second current 12 as input. Further, the fourth MOSFET 22b is connected with its drain to the source of the third MOSFET 22a and with its source to ground. A resistor 24 is connected from the output of the op-amp 23 to ground.

The gate of the third MOSFET 22a is connected to the inverse 14 of the control signal 13, and the gate of the fourth MOSFET 22b is connected to the control 13.

In use, when the control signal 13 is ON, MOSFET 21a and 22b will be ON, thus connecting the first current 11 to the op-amp 23 and the second current I2 to ground. When the control signal 13 is OFF, MOSFET 22a and 21b will be ON, thus connecting the second current I2 to the om-amp 23 and the first current I1 to ground.

The person skilled in the art realizes that the present invention by no means is limited to the preferred embodiments described above. On the contrary, many modifications and variations are possible within the scope of the appended claims. For example, although the herein described embodiment of the invention uses N-channel MOSFETs of enhancement type, the invention is generally relevant for any MOSFETs having an integrated body diode. Consequently, similar advantages may be achieved with P-channel MOSFETs as well as depletion-type MOSFETs, as long as appropriate adjustment of the circuitry and control signals are made.

## Claims

1. An analogue current switch comprising:
an operational amplifier (2; 23) having a positive input connected to ground, and a negative input,
a first field effect transistor (3) connected between the negative input of the operational amplifier and a current-input terminal of the analogue switch,
a second field effect transistor (4) connected between the current-input terminal and ground,
wherein a gate (12) of the first field effect transistor is connected to a control signal (13), and a gate (15) of the second field effect transistor is connected to an inverse (14) of said control signal,
**characterized in that**
said first and second field effect transistors are metal oxide semiconductor field effect transistors (MOSFETs).

2. The analogue current switches according to claim 1, wherein the first field effect transistor has a drain connected to the negative input of the operational amplifier, and a source connected to the input terminal.

3. The analogue current switches according to claim 2, wherein the second field effect transistor has a drain connected to the source of the first field effect transistor, and a source connected to ground.

4. The analogue current switches according to one of claims 1 - 3, further comprising:
a third MOSFET (22a) having a drain connected to the negative input of the operational amplifier and a source serving as a second input of the analogue switch,
a fourth MOSFET (22b) having a drain connected to the source of the third MOSFET 22a and a source connected to ground,
wherein a gate of the third MOSFET is connected to an inverse (14) of said control signal, and a gate of the fourth MOSFET is connected to said control signal (13).

5. The analogue current switch according to one of the preceding claims, wherein the MOSFETs are N-channel MOSFETs.

6. The analogue current switch according to any one of the preceding claims, wherein the MOSFETs are of enhancement type.
